(19) Europäisches Patentamt

European Patent Office

Office européen des brevets

(11) Publication number : **0 501 685 A1**

(12) # EUROPEAN PATENT APPLICATION

(21) Application number : **92301437.7**

(22) Date of filing : **21.02.92**

(51) Int. Cl.⁵ : **G03F 7/32, C11D 3/26, C11D 7/26, C11D 3/20, C11D 7/50, C11D 3/43**

(30) Priority : **28.02.91 US 661979**

(43) Date of publication of application :
**02.09.92 Bulletin 92/36**

(84) Designated Contracting States :
**DE FR GB IT**

(71) Applicant : **AMERICAN TELEPHONE AND TELEGRAPH COMPANY**
**550 Madison Avenue**
**New York, NY 10022 (US)**

(72) Inventor : **Fang, Treliant**
**36 Fairfield Avenue**
**Lawrenceville, New Jersey 08648 (US)**
Inventor : **Gillum, William Olden**
**192 Pennington-Harbourton Road**
**Pennington, New Jersey 08534 (US)**

(74) Representative : **Johnston, Kenneth Graham et al**
**AT&T (UK) LTD. AT&T Intellectual Property Division 5 Mornington Road**
**Woodford Green Essex, IG8 OTU (GB)**

(54) **Organic solvents comprising butyl butyrate.**

(57)    Polymeric photodefinable layers (13) are developed by exposing them to a solvent (17) comprising butyl butyrate. Butyl butyrate is also used as a cleaner of organic contaminants.

EP 0 501 685 A1

## Technical Field

This invention relates to organic material solvents and, more particularly, to developers for photoresists and to cleaning solutions.

## Background of the Invention

Photoresists, or photodefinable materials, are materials that respond to actinic light to permit selective patterning of a layer of the material. The process of selectively exposing photoresist to light projected through a photomask so that the photoresist may be used as a mask to permit selective processing of an underlying substrate is known generally as photolithography, and is widely used for defining electronic circuits on semiconductors, ceramic substrates and printed wiring boards.

The U.S. patent of Small, No. 4,601,972, granted July 22, 1986, describes a photoresist material which, in addition to being used for masking, constitutes a useful dielectric for subsequent use in an electronic circuit. The materials described function as negative photoresists; that is, development of the material dissolves those areas that have not been exposed to light, while leaving intact areas of the layer which have been exposed to actinic light. Thus, after development, the remaining areas define an image which is a negative image of the photomask used for selective exposure. The photodefinable compositions of the Small patent are all triazene epoxy acrylates; epoxy acrylates other than those described in the patent are also known and used as negative photoresists. Such photoresists are initially uncured, and exposure to actinic light essentially cures, or crosslinks, the part of the layer so exposed, which permits the uncured portion to be selectively dissolved by an appropriate solvent.

A commonly used solvent for developing epoxy acrylate negative photoresist is 1,1,1-trichloroethane (TCE). Unfortunately, TCE is a chlorohydrocarbon which partially volatilizes during use, and is one of many compounds known as ozone depleters, the use of which tends to deplete the ozone layer of the upper atmosphere with harmful consequences to the earth's environment. Concerted international efforts have been made and are being made to find replacements for such substances. To be practical, any such replacement must be appropriately selective in dissolving the unexposed photoresist, be of appropriately low toxicity and with a sufficiently high flash point so as not to be dangerous to the operators, and should be reusable and water immiscible so as to avoid water pollution.

One proposed replacement for TCE is propylene glycol methyl ether acetate (PGMEA). PGMEA has a low flash point of one hundred ten degrees Fahrenheit, which implies that strict safety measures must be taken during use. It has a threshold limit value (TLV) of one thousand parts per million (PPM), which implies a toxicity sufficiently high to be of concern. Accordingly, there is a continued need in the industry for an appropriate replacement for TCE as a photoresist developer.

## Summary of the Invention

We have found that polymeric photodefinable layers can be developed by exposing them to a solvent comprising predominantly butyl butyrate. This solvent is not an ozone depleter, it yields a better developed image than TCE, is of low toxicity, has a high flash point, is water immiscible, and is stable at atmospheric pressure. The material is relatively inexpensive and can be used in the form in which it is commercially available, which is as a liquid of about ninety-nine percent butyl butyrate. The butyl butyrate may be applied by nozzle spray in the same general manner that known developers are applied.

We have also found that butyl butyrate is useful as a general solvent for organic materials. Specifically, it is useful for cleaning greases and oils from metals and rosin flux residue from printed wiring boards. As such, it is promising as a replacement for chlorofluorocarbons (CFC's), ozone depleters which are widely used for cleaning, as well as CFC replacements such as terpenes, which have other disadvantages that can be avoided by butyl butyrate.

These and other objects, features and advantages of the invention will be better understood from a consideration of the following detailed description taken in conjunction with the accompanying drawing.

## Brief Description of the Drawing

FIG. 1 is a schematic view of apparatus for applying photoresist developer in accordance with an illustrative embodiment of the invention; and

FIG. 2 is : schematic view of part of a photoresist layer after development.

## Detailed Description

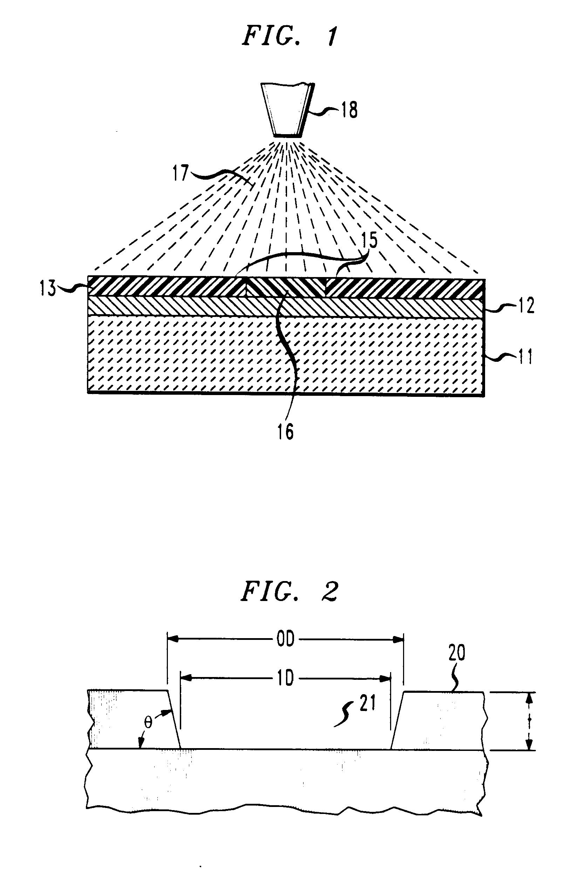

Referring now to FIG. 1, there is shown a schematic view of apparatus for applying photoresist developer in accordance with the illustrative embodiment of the invention. The Figure, which is not drawn to scale, shows illustratively a substrate body 11, which may be a ceramic substrate, having on an upper surface a metal layer 12. Overlying the metal layer is a photoresist coating 13. The photoresist coating has been selectively exposed to actinic light projected through a photomask in accordance with known photolithographic methods. Areas 15 of the photoresist have been exposed to actinic light while area 16 has been shielded from the light by the photomask.

The photoresist coating 13 is illustratively a polymer, a known epoxy acrylate, which acts as a negative photoresist; that is, after development, the image formed by the photoresist is a negative image of the image defined in the photomask. Actinic light, which impinges on areas 15 of the photoresist, causes crosslinking of component molecules, or in other words cures the polymeric material on which it impinges.

In accordance with the invention, the photoresist coating 13 is developed by spraying it with liquid butyl butyrate 17 from a nozzle 18. Butyl butyrate is a benign material heretofore used as a food additive, which we have found is particularly good for selectively dissolving uncured epoxy acrylate, thereby to develop the photoresist layer 13. That is, the butyl butyrate 17 dissolves the portion 16 of the photoresist coating that has not been exposed to light while leaving intact the portion 15 that has been exposed to light.

The butyl butyrate that we have used is in the form in which it is commercially available, for example, from the Haarman and Reimer Company of Springfield, New Jersey, that is, in liquid form which is more than ninety-nine percent butyl butyrate. The photoresist with which the invention was used is a composition described in the aforementioned Small patent, which is basically fifty percent triazene, twenty percent acrylated acrylonitrile butadiene rubber, nine percent half acrylate of the diglycidyl ether of bisphenol-A, nine percent N-vinylpyrrolidone, four percent trimethylolpropanetriacrylate, two percent glycidoxypropyltrimethoxysilane, and added to the basic formula is the following: two percent 2,2-dimethoxy-2-phenylacetophenone, 0.5 percent magenta pigment, 0.2 percent surfactant, and 0.5 percent copper benzyl acetonate. The thickness of the photoresist was forty-three to fifty-four microns.

Referring to FIG. 2, assume that a photoresist 20 has a thickness $t$. Assume further that all but a rectangular portion in the layer has been exposed to light. When the film is developed, the unexposed portion will be dissolved by the developer solution leaving in the film a rectangular opening 21. With the developer spray being applied as shown in FIG. 1, the opening will normally have a larger diameter OD at the top surface of the layer than the diameter ID at the bottom surface of the layer. As a consequence, the side walls of the opening slope at an angle $\theta$ with respect to the horizontal. One measure of the quality of development is the angle $\theta$; the closer the angle $\theta$ is to ninety degrees and the closer the outer diameter is to the inner diameter, the sharper the image is that has been developed by the developer solution. Table I shows measurements of these parameters for various exposures of the photoresist material described above.

## Table I

| Solvent | Thickness($\mu$) | Dose(mJ/sq cm) | OD($\mu$) | ID($\mu$) | $\theta$ |
|---------|------------------|----------------|-----------|-----------|----------|
| BuBu | 43.6(44.3) | 400 | 195(195) | 125(163) | 51°(70) |
| BuBu | 45.2 | 600 | 192 | 121 | 52° |
| BuBu | 45.2(40.3) | 800 | 184(182) | 115(163) | 53°(77) |
| BuBu | 49.0 | 1000 | 181 | 110 | 54° |
| TCE | 40.2 | 1000 | 197 | 132 | 51° |
| BuBu | 47.3(56.1) | 1200 | 183(188) | 112(165) | 53°(78) |
| BuBu | 52.3 | 1400 | 184 | 105 | 53° |
| BuBu | 47.2 | 1680 | 181 | 104 | 51° |
| TCE | 49.4(54.4) | 1800 | 192(201) | 110(175) | 50°(77) |
| BuBu | 54.0(55.8) | 2000 | 175(185) | 96(149) | 54°(72) |

The symbol BuBu refers to butyl butyrate. The thickness refers to the thickness $t$ of FIG. 2, while $\mu$ means microns. The main thickness and diameter measurements were made by a profilometer, while those measurements enclosed in parenthesis were made by a scanning electron microscope (SEM). The angles are probably more dependably measured by the SEM than by the profilometer because of structure problems in making the profilometer measurement. The dose in milli-Joules per square centimeter refers to the actinic power which was used to expose the photoresist. Parameters OD, ID and $\theta$ correspond to those parameters of FIG. 2. After exposure, the photoresist was baked at fifty degrees Centigrade in a closed box for thirty minutes and was thereafter held for eighteen hours. The developer was sprayed from a nozzle about four inches from the surface of the photoresist with a flow rate of two milliliters per second and a thirty-five second development time. The butyl butyrate was that commercially available from the Haarman and Reimer Company of Springfield, New Jersey. A water rinse of thirty-five seconds was used. The results show that the OD parameters and the angle parameters for butyl butyrate compare favorably with TCE and, indeed, are more favorable than TCE, which indicates that butyl butyrate gives sharper definition than TCE when used as a developer. We estimate that the nozzle can be two to five inches from the substrate, situated either vertically or horizontally, the substrate can be moved past a plurality of nozzles in a mass production system, the pressure of the developer may be from five to sixty pounds per square inch, and the developing time, that is, the time the developer is in contact with the photoresist prior to rinse, may be between twenty seconds and ninety seconds.

As mentioned before, a principal advantage of butyl butyrate over TCE is that butyl butyrate is not an ozone depleter. It has low toxicity as reflected by its use as a food additive. Its high flash point (temperature of ignition with a spark) is one hundred twenty-eight degrees Fahrenheit, which is sufficiently high to be consistent with safe use and is considerably higher than that of other solvents that were tested. It is water immiscible; that is, it can be rinsed by water and it separates easily from water after rinse so that it can easily be recovered for reuse. It appears to have a maximum loading of up to five percent, which is sufficient for most purposes; that is, it can dissolve up to five percent of its own weight. It is readily commercially available at a relatively inexpensive cost. Because of its low volatility, most of it can be recovered for reuse. Most of the TCE that is used, for example, for photoresist development is lost because of its high volatility, and additives must be added to it for stability. Butyl butyrate is stable at atmospheric pressure up to its boiling point (167°C).

It should be noted that the various forms of butyl butyrate that are known are expected to work in the same manner as commercially available butyl butyrate. Consequently, the term "butyl butyrate" should be interpreted as including n-butylisobutymte, isobutyl-n-butyrate, and isobutyl-isobutyrate. Likewise, it is expected that the invention will work equally well on the other formulations described in the Small patent, as well as other epoxy acrylate type polymer photoresists. The solubility of uncured epoxy acrylate in butyl butyrate suggests that butyl butyrate may be useful as a nonpolluting and recoverable cleaner of polymer and other organic material contaminants.

One field in which cleaning of metals is important is the pre-plate cleaning of connector pins which is one step in the fabrication of electronic devices. Many manufacturers use chlorofluorocarbon materials such as Freon, commercially available, for example, from the DuPont Company of Wilmington, Delaware, which are ozone depleters and which are particular targets for replacement.

In experimentally determining the efficiency of butyl butyrate as a metal cleaner, metal strips 1.5 by two inches of CA725 metal alloy, an alloy of copper, nickel and tin, were initially cleaned in the following manner:

1. First, the strips were ultrasonically cleaned for nine seconds in a solution of fifty percent water and fifty percent Bioact (TM) EC-8, which is a mixture of esters, commercially available from the Petroferm Company of Fernandina Beach, Florida. The ultrasonic cleaner was a Branson ultrasonic cleaner, available from the Branson Company of Danbury, Connecticut. All ultrasonic procedures here and below employed the Branson unit filled with water in which a glass beaker containing the cleaning solution was placed for the test.

2. They were then given a five second deionized water rinse.

3. They were ultrasonically cleaned for nine seconds in fifty percent Bioact EC-8.

4. They were rinsed in deionized water for five seconds.

5. They were blow dried with nitrogen.

6. After the cleaning described above, all samples were tested for surface contamination using an OP 1020 photoemission spectrometer, a spectrometer commercially available from Photo Acoustic Technology, Inc. of Westlake Village, California. All cleaned samples gave a reading of three hundred to four hundred, which was a measure of photoemitted electrons ejected from the substrate in response to impingement by light. Any organic contaminant film reduces the photoemission and thus the count.

The metal strips were then all uniformly contaminated by dipping them in a ten to one solution of Magnus L67 lubricating oil, available from the Economics Laboratory, Inc. of St. Paul, Minnesota, and Hangsterfer All Draw oil, available from the Hangsterfer Laboratory, Inc. of Mantua, New Jersey and allowed to dry for twenty-four hours. This coating is considered the equivalent of hydrocarbon contamination occurring during fabrication. No photoemission signal was obtained from the coated samples.

The cleaning process used was intended to follow closely, or to mimic, an electronic pin pre-plate cleaning process used by AT&T in making electronic devices, and it proceeded as follows:

1. Samples were ultrasonically cleaned for nine seconds at room temperature in the solution being tested. Each sample was in a beaker of the solution being tested which was placed in a tank of water surrounded by the acoustic transducer of the ultrasonic cleaning apparatus.

2. The samples were rinsed in deionized water by the overflow process until the rinse water cleared which usually was fifteen to twenty seconds.

3. Samples were ultrasonically cleaned for nine seconds at room temperature in the solution being tested.

4. The samples were again rinsed in deionized water by the overflow process until the water again cleared, typically in five to twenty seconds.

5. Samples were dipped for eighteen seconds in room temperature ten percent sulfuric acid.

6. The samples were again rinsed in deionized water by the overflow process until the water again cleared, typically in five to twenty seconds.

7. The samples were dried with room temperature nitrogen.

The samples were measured for cleanliness by the OP 1020 photoemission spectrophotometer, with the results shown in Table II.

## TABLE II

| Cleaner | Trial 1 | Trial 2 | Trial 3 | Trial 4 | Average |
|---|---|---|---|---|---|
| Bioact EC-8 | 247 | 181 | 183 | | 204 |
| Butyl Butyrate | 318 | 300 | 245 | 220 | 271 |
| CFC 113 | 2 | 2 | 18 | | 7 |

Table II shows that the cleaning efficiency of butyl butyrate was much better than that of CFC 113 and significantly better than Bioact EC-8, both of which are being used commercially for pre-plate cleaning purposes. Butyl butyrate is therefore efficacious for cleaning grease and oils from metals, and particularly for use as a replacement for ozone depleters in metal cleaning operations prior to plating of such metals.

Another challenging cleaning problem in the electronics production industry is that of cleaning rosin flux from newly produced printed wiring boards and other substrates. Rosin flux is widely used to promote solder bonding in such apparatus. The efficiency of butyl butyrate as a cleaner in printed wiring board fabrication processes was determined by first preparing fiberglass circuit board test coupons of four inches by four inches and using the following process, which was intended to mimic a commercial fabrication process:

1. The test coupons were coated with an 8130 dry film solder mask, available from the DuPont Company of Wilmington, Delaware, and were cleaned ultrasonically with one hundred percent isopropanol at ninety degrees Fahrenheit for two minutes.
2. The coupons were air dried overnight.
3. The tare weight of each coupon was taken.
4. Eighty percent of each coupon was coated with RMA321 rosin flux, available from Alpha Metals of Jersey City, New Jersey.
5. The flux was reflowed at two hundred degrees Centigrade for two minutes in a convection oven.
6. The coupons were held in air for about sixty hours.

Comparative flux removal was made using butyl butyrate, Freon TMS, commercially available from the Textile Chemical Company of Reading, Pennsylvania, Bioact EC-7, a terpene cleaner commercially available from the Petroferm Company of Fernandina Beach, Morida, isopropanol, commercially available from the J. T. Baker Company of Phillipsburg, Pennsylvania, and Exxate 600, a hexyl acetate cleaner commercially available from the Exxon Chemical Company of Houston, Texas. The experiment runs were conducted as follows:

1. Eight hundred milliliters of the cleaning solution was stirred in a glass beaker with a magnetic stirring plate until a vortex formed.
2. The coupon was held in the solvent with the flux side down for one minute, while the coupon was agitated up and down by hand.
3. The coupon was air dried for thirty minutes.
4. The coupon was dried for one half hour at eighty degrees Centigrade.
5. The coupon was weighed.

The weight of the flux removed was normalized for the area covered on the coupon to account for differences in area covered by flux. The three values for each run were averaged and are set forth in Table III.

## TABLE III

| Cleaning Liquid | Run Temperature | Flash Point (°F) (Closed Cup) | Normalized Flux Weight Loss (gm) |
|---|---|---|---|
| Butyl Butyrate Run 1 | Room Temperature 72°F | 127 | 2.17 |
| Butyl Butyrate Run 2 | Room Temperature 72°F | 127 | 2.00 |
| Freon TMS | Room Temperature | - | 2.14 |
| Bioact EC-7 | Room Temperature | 117 | 1.68 |
| Isopropanol | Room Temperature | 56 | 0.80 |
| Exxate 600 | Room Temperature | 134 | 2.34 |

The Table shows that the normalized weight loss using butyl butyrate was greater than that using Freon TMS, Bioact EC-7, or isopropanol. The greater weight loss indicates a greater effectiveness in removing rosin solder flux from the coupons under test. The Exxate 600 appeared to have a greater effectiveness, but that material has a threshold limit value (TLV) of fifty parts per million, and thus it is of greater toxicity than butyl butyrate. These tests demonstrate that butyl butyrate is effective as a substitute for ozone depleting cleaners for the purpose of cleaning rosin flux in the manufacture of printed wiring boards.

The foregoing experiments suggest that butyl butyrate could be used as an active ingredient in other cleaning formulations. Electrical sockets may be cleaned with a mixture of butyl butyrate, mineral spirits, nonionic surfactants and water. It is expected that formulations could be made containing five to one hundred percent butyl butyrate, ten to ninety-five percent mineral spirit (boiling point of one hundred eighty degrees Centigrade), zero to fifty percent nonionic surfactants and zero to ninety percent water. The greater cleaning power and low viscosity as well as the other advantageous properties of butyl butyrate mentioned above make this formulation attractive for cleaning electrical sockets. In all of the experiments described above, the butyl butyrate was unchanged from the liquid form, commercially available from the Haarman and Reimer Company of Springfield, New Jersey, which is over ninety-nine percent pure.

The embodiments described are intended to be merely illustrative of the inventive concept. Particularly, the organic material dissolving ability of butyl butyrate rakes it useful for cleaning organic contaminants from substrates which may be of any material. The cleaning steps described were intended to compare the use of butyl butyrate to other cleaners and are not intended to limit the ways in which it may be use as a cleaner. For example, ultrasonic agitation is not essential for cleaning, nor is a water rinse; rather, they are convenient methods of cleaning. The time taken to dissolve an organic material is quite short and exposure beyond the minimum time is not necessarily harmful. Cleaning merely requires sufficient exposure to allow dissolution, and the time taken, method of application, method of agitation, method of rinse, etc., do not appear to be critical. Other modifications and embodiments may be made by those skilled in the art without departing from the spirit and scope of the invention.

## Claims

1. A photolithography method comprising the steps of:

   covering a substrate surface with a thin layer of substantially uncured polymeric photodefinable material;

   selectively exposing the layer to radiant energy projected through an imaging mask to selectively cure part of the photodefinable material;

   and developing the polymeric photodefinable material by exposing it to a solvent that selectively

7

dissolves areas of the layer that have not been cured and leaving substantially intact areas of the layer that have been substantially cured, characterized in that:

the solvent comprises predominantly butyl butyrate.

2. The method of claim 1 characterized in that:

the photodefinable layer comprises an epoxy acrylate prepolymer formed by reaction of acrylic acid and bisphenol-A diglycidyl ether.

3. The method of claim 1 characterized in that:

the photodefinable material contains an acrylate polymer.

4. The method of claim 3 wherein:

the solvent is substantially pure butyl butyrate.

5. A method for cleaning polymeric contamination from an article comprising the steps of exposing the polymeric contamination to a solvent for a sufficient length of time to dissolve such contamination, and removing the solvent from the article, characterized in that:

the solvent comprises butyl butyrate.

6. The method of claim 5 wherein:

the solvent is an aqueous emulsion comprising five to one hundred percent butyl butyrate.

7. The method of claim 5 wherein:

the solvent consists essentially of pure butyl butyrate.

8. The method of claim 5 wherein:

the polymeric contarminant is a rosin flux.

9. A method for removing organic material from a substrate comprising the steps of exposing the organic material to a solvent for a sufficient time to dissolve such organic material and removing the solvent from the substrate, characterized in that:

the solvent comprises butyl butyrate.

10. The method of claim 9 wherein:

the organic material is uncured photoresist material.

11. The method of claim 9 wherein:

the solvent consists essentially of pure butyl butyrate.

12. The method of claim 11 wherein:

the substrate is covered with photoresist, part of which is exposed to actinic light;

and the solvent is used to dissolve and remove photoresist material that has not been exposed to the actinic light.

13. The method of claim 12 wherein:

the organic material is a rosin flux;

and the substrate is a printed wiring board.

14. The method of claim 12 wherein:

the organic material is a hydrocarbon contaminant of the substrate.

15. The method of claim 12 wherein:

the article is immersed in the solvent;

and during immersion, the solvent is subjected to acoustic agitation.

16. The method of claim 9 wherein:

a solvent is a solution comprising five to one hundred percent butyl butyrate, ten to ninety-five percent mineral spirit, zero to fifty percent nonionic surfactants, and zero to ninety percent water.

## FIG. 1

## FIG. 2

European Patent
Office

**EUROPEAN SEARCH REPORT**

Application Number

EP 92 30 1437

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 365 987 (HOECHST AG)<br>* the whole document *<br>--- | 1-16 | G03F7/32<br>C11D3/26<br>C11D7/26 |
| X | EP-A-0 065 381 (N.H. SHUTTLEWORTH)<br>* the whole document *<br>--- | 5-9 | C11D3/20<br>C11D7/50<br>C11D3/43 |
| X | DE-A-3 913 911 (R. JANSEN)<br>* the whole document *<br><br>----- | 5-9 | |

**TECHNICAL FIELDS SEARCHED (Int. Cl.5)**

G03F
C11D

The present search report has been drawn up for all claims

| Place of search | Date of completion of the search | Examiner |
|---|---|---|
| THE HAGUE | 03 JUNE 1992 | HAENISCH U.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)